# EUROPEAN PATENT SPECIFICATION

(11) **EP 4 395 524 B1**
(45) Date of publication and mention of the grant of the patent: **30.07.2025**
(21) Application number: 23220497.4
(22) Date of filing: 28.12.2023
(51) Int. Cl.: H10N 60/30, H10N 60/80, H10N 60/01, H01F 6/06

(54) **NON-INDUCTIVE COIL ASSEMBLY AND MANUFACTURING METHOD THEREFOR**
NICHT-INDUKTIVE SPULENANORDNUNG UND VERFAHREN ZU DEREN HERSTELLUNG
ENSEMBLE BOBINE NON INDUCTIVE ET SON PROCÉDÉ DE FABRICATION

(30) Priority: 30.12.2022 CN 202211725707
(43) Date of publication of application: 03.07.2024
(73) Proprietor: Siemens Healthcare Limited, Camberley, Surrey GU15 3YL (GB)
(72) Inventor: NIE, Yu Xin, Shenzhen 518128 (CN); HE, Jianping, Shenzhen 518071 (CN); HE, Bin, Shenzhen 518000 (CN); WU, Jun Zhao, Shenzhen 518052 (CN)
(74) Representative: HKW Intellectual Property PartG mbB

(56) References cited:
- EP-B1- 3 803 916
- JP-A- H02 130 879
- JP-A- S5 929 306

## Description

### TECHNICAL FIELD

The present invention relates to the technical field of superconductors, and especially to a non-inductive coil assembly and a manufacturing method therefor.

### BACKGROUND ART

Superconducting magnets are widely used in MRI systems, because they may provide a strong magnetic field with high stability. A superconducting switch is an important component; it is connected in parallel to two ends of a superconducting coil to achieve closed-loop motion of current in a superconducting magnet. A superconducting switch has two working states: a normal state (resistance state) and a superconducting state (no-resistance state). Before increasing/reducing magnet current, the superconducting switch is driven to the normal state by a heater. After the required current is reached, the heater is turned off, and the superconducting switch changes to the superconducting state, causing current to pass through without resistance.

The superconducting switch is generally formed by winding multiple twisted strands of superconducting wire. In order to reduce a reactance effect thereof on a circuit and environment as much as possible, conducting wire in the switch should be wound into a non-inductive coil. Key to manufacturing a superconducting switch is to use a winding method for a non-inductive coil with stable performance.

A mainstream method for winding a non-inductive superconducting switch is a "dual-wire winding method". Patent CN1056245C and patent CN102394269A both disclose a non-inductive coil winding method; as shown in Fig. 1, a superconducting wire rod 20 is bent by 180 degrees at a midpoint in the length thereof, and, in order to prevent the superconducting wire rod from being damaged at a fold 201, the folded radius cannot be too small; next, two half superconducting wire rods are wound on a winding frame by the same number of turns. In the winding process, the tension and speed of the two half superconducting wire rods should be kept the same. After winding, two ends of the multi-strand conducting wire come out from the coil at the same place. This type of dual-wire winding coil may be seen as a combination of two sub-coils wound in opposite directions. When current is input from one end and output from the other end, the directions of the current in the two sub-coils are exactly opposite each other, thereby achieving non-inductance in the overall coil.

Other examples on non-inductive coils can be found, for example, in JP H02-130879 A and JP S59-29306 A.

However, a non-inductive coil made using the above-mentioned dual-wire winding method is not completely non-inductive, because the current input conducting wire and output conducting wire in the coil do not fully coincide with each other spatially; the position in space of one sub-coil of the two sub-coils is displaced with respect to the other. Moreover, conducting wire of a folded region also does not coincide significantly in space. These factors result in a dual-wire winding superconducting switch having a small inductance, which produces a negative effect on a circuit and environment.

In addition, at a midpoint, the superconducting wire is bent by 180 degrees, which also causes the superconducting wire to easily break at the wire-bending point. Moreover, controlling the dual-wire winding process is difficult, it is difficult to keep tension values of the two conducting wires exactly the same at any given time, and fluctuations in tension in the conducting wires reduce stability of the superconducting switch in operation.

### SUMMARY OF THE INVENTION

The technical problem to be solved by the present invention is to provide a non-inductive coil assembly and manufacturing method therefor, in order to overcome the defect of a non-inductive coil in the prior art easily generating inductance, producing an undesirable effect on a circuit and environment.

The present invention achieves the above-mentioned technical effects by means of the following technical solutions:
The present invention provides a non-inductive coil assembly, the non-inductive coil assembly comprising:
a superconducting joint, the superconducting joint configured to be conductive; and
a superconducting coil, the superconducting coil comprising an even number of conducting wires, the even number of conducting wires being helically wound together, a first end of the superconducting coil being connected to the superconducting joint, and, at a second end of the superconducting coil, the even number of conducting wires dividing into two strands and being respectively helically wound to form an input group and an output group, the numbers of conducting wires of the input group and the output group being the same, and current flowing to the superconducting joint via the conducting wire corresponding to the input group, and flowing out of the superconducting coil from the conducting wire corresponding to the output group.

In the present solution, one half of the conducting wire in the superconducting coil corresponds to the input group, the direction of current flows from the input group to the superconducting joint, the other half of the conducting wire in the superconducting coil corresponds to the output group, the direction of current flows from the superconducting joint to the output group, and the directions of current of the two are opposite each other, and thus, the superconducting coil as a whole may be seen as a combination of two sub-coils wound in opposite directions, such that the overall superconducting coil is non-inductive. In this type of innovative superconducting coil of the present solution, two parts of conducting wire, in which the directions of current are opposite each other, are helically wound together to form a coil, and an amount of displacement of position in space between the two conducting wires, in which the directions of current are opposite each other, is relatively small, causing a reactance effect of the superconducting switch on a circuit and environment to be minimal. In addition, the present solution replaces a conducting wire folded part of a "dual-wire winding method" with the superconducting joint, so that an amount of inductance of a bent region is thereby eliminated, and the superconducting wire can also be prevented from breaking at the fold. Moreover, in the present solution, because only one whole superconducting coil is wound, compared with the "dual-wire winding method", the winding process of the present invention is simpler, tension of the wire is also easier to control, and this increases stability of the superconducting switch when operating.

Preferably, the superconducting joint is configured such that resistance of the superconducting joint is zero when the temperature reduces to a threshold value. In the present solution, the superconducting joint being provided with the above property can realize a superconducting connection between the superconducting coil and the superconducting joint, and, in a low temperature situation, resistance at the superconducting joint is zero, which prevents the superconducting joint from influencing the operating performance of the superconducting switch in a no-resistance state.

Preferably, the non-inductive coil assembly comprises a cylindrical winding frame, the superconducting coil is wound on an outer wall face of the winding frame, and the superconducting joint is connected to the winding frame.

In the present solution, using the above structural configuration, the structure is simple which facilitates manufacturing.

Preferably, the winding frame is provided with an accommodating slot, and the superconducting joint is clamped in the accommodating slot.

In the present solution, by means of providing the accommodating slot, the superconducting joint can be fixed, and at the same time, the superconducting joint is prevented from affecting the arrangement of the superconducting coil on the winding frame.

Preferably, two end faces of the winding frame are provided with a winding end plate, the winding end plate is provided with an accommodating slot, and the superconducting joint is clamped in the accommodating slot.

In the present solution, by means of providing the winding end plates, the superconducting coil can be prevented from coming off two ends of the winding frame, the accommodating slot is arranged on the winding end plate, and does not affect the winding of the superconducting coil on the winding frame.

Preferably, after the superconducting joint is heated to melting point and becomes liquid, the first end of the superconducting coil is inserted inside the superconducting joint of a liquid state, and thereafter, reducing the temperature causes the superconducting joint to change to a solid state, to cause the superconducting coil to fix to the superconducting joint.

In the present solution, using the above structural form, while the superconducting coil is fixed to the superconducting joint, current can flow from the conducting wire corresponding to the input group into the conducting wire corresponding to the output group by means of the superconducting joint. Preferably, the superconducting joint is cylindrical.

Preferably, the material of the superconducting joint is a lead bismuth alloy.

In the present solution, the melting point of the lead bismuth alloy is low, convenient for heating same to a liquid state, so that the processing efficiency of the superconducting joint is high; in addition, the resistivity of the lead bismuth alloy decreases sharply under the effect of a magnetic field, convenient for causing the resistance of the superconducting joint to be zero at a low temperature, thereby realizing a superconducting connection between the superconducting joint and the superconducting coil.

The present invention further provides a manufacturing method for a non-inductive coil assembly, the method being used for manufacturing the non-inductive coil assembly described above, and the manufacturing method comprising the following steps:
S1, helically winding the even number of conducting wires together to form the superconducting coil;
S2, fixing a first end of the superconducting coil to the superconducting joint; and
S3, at a second end of the superconducting coil, dividing the superconducting coil into two strands of the same number of conducting wires, and respectively helically winding the strands to form an input group and an output group, wherein when the superconducting coil is energized, current flows from the input group to the output group.

In a present solution, one half of the conducting wire in the superconducting coil corresponds to the input group, the direction of current flows from the input group to the superconducting joint, the other half of the conducting wire in the superconducting coil corresponds to the output group, the direction of current flows from the superconducting joint to the output group, and the directions of current of the two are opposite each other, and thus, the superconducting coil as a whole may be seen as a combination of two sub-coils wound in opposite directions, such that the overall superconducting coil is non-inductive. In this type of innovative superconducting coil of the present solution, two parts of conducting wire, in which the directions of current are opposite each other, are helically wound together to form a coil, and an amount of displacement of position in space between the two conducting wires, in which the directions of current are opposite each other, is relatively small, causing a reactance effect of the superconducting switch on a circuit and environment to be minimal. In addition, the present solution replaces a conducting wire folded part of a "dual-wire winding method" with the superconducting joint, so that an amount of inductance of a bent region is thereby eliminated, and the superconducting wire can also be prevented from breaking at the fold. Moreover, in the present solution, because only one whole superconducting coil is wound, compared with the "dual-wire winding method", the winding process of the present invention is simpler, tension of the wire is also easier to control, and this increases stability of the superconducting switch when operating.

Preferably, the non-inductive coil assembly further comprises a cylindrical winding frame, and the following steps are further comprised between step S2 and step S3:
S21, fixing the superconducting joint to the winding frame; and
S22, winding the superconducting coil on the winding frame.

On the basis that common knowledge in the art is conformed to, the above preferred conditions may be combined in any way to obtain preferred examples of the present utility model.

A positive further effect of the present invention lies in: regarding the non-inductive coil assembly, one half of the conducting wire in the superconducting coil corresponds to the input group, the direction of current flows from the input group to the superconducting joint, the other half of the conducting wire in the superconducting coil corresponds to the output group, the direction of current flows from the superconducting joint to the output group, and the directions of current of the two are opposite each other, and thus, the superconducting coil as a whole may be seen as a combination of two sub-coils wound in opposite directions, such that the overall superconducting coil is non-inductive. In this type of innovative superconducting coil of the present solution, two parts of conducting wire, in which the directions of current are opposite each other, are helically wound together to form a coil, and an amount of displacement of position in space between the two conducting wires, in which the directions of current are opposite each other, is relatively small, causing a reactance effect of the superconducting switch on a circuit and environment to be minimal. In addition, the present solution replaces a conducting wire folded part of a "dual-wire winding method" with the superconducting joint, so that an amount of inductance of a bent region is thereby eliminated, and the superconducting wire can also be prevented from breaking at the fold. Moreover, in the present solution, because only one whole superconducting coil is wound, compared with the "dual-wire winding method", the winding process of the present invention is simpler, tension of the wire is also easier to control, and this increases stability of the superconducting switch when operating.

### BRIEF DESCRIPTION OF THE DRAWINGS

Embodiments of the present invention are described in detail below with reference to the accompanying drawings, to give those skilled in the art a clearer understanding of the abovementioned and other features and advantages of the present invention. Drawings:

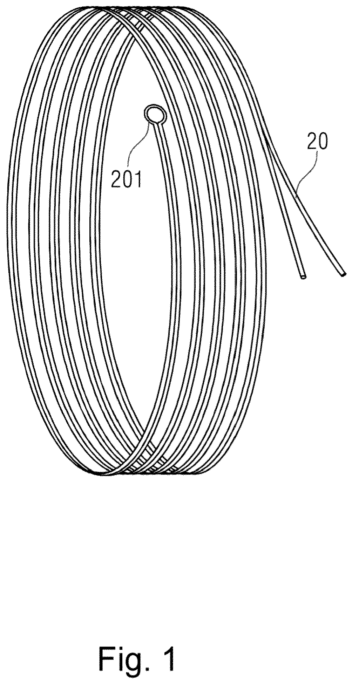

Fig. 1 is a three-dimensional schematic structural diagram of a non-inductive superconducting switch in the background art.
Fig. 2 is a three-dimensional schematic structural diagram of a non-inductive coil assembly according to a preferred embodiment of the present invention, wherein a helical winding manner of conducting wire is not shown.
Fig. 3 is a three-dimensional schematic structural diagram of a superconducting joint according to a preferred embodiment of the present invention.
Fig. 4 is a sectional view of a superconducting coil according to a preferred embodiment of the present invention.

In Background Art, the reference labels are as follows:
Superconducting wire rod 20
Fold 201

In the present invention, the reference labels are as follows:
Non-inductive coil assembly 100
Superconducting joint 101
Superconducting coil 102
Input group 103
Output group 104

### DETAILED DESCRIPTION OF THE INVENTION

To enable a clearer understanding of the technical features, objectives and effects of the present invention, particular embodiments of the present invention are now explained with reference to the accompanying drawings, in which identical labels indicate identical parts.

As used herein, "schematic" means "serving as an instance, example or illustration". No drawing or embodiment described herein as "schematic" should be interpreted as being a more preferred or more advantageous technical solution.

To make the drawings appear uncluttered, only those parts relevant to the present invention are shown schematically in the drawings; they do not represent the actual structure thereof as a product. Furthermore, to make the drawings appear uncluttered for ease of understanding, in the case of components having the same structure or function in certain drawings, only one of these is drawn schematically, or only one is marked.

In this text, "a" does not only mean "just this one"; it may also mean "more than one". As used herein, "first" and "second" etc. are merely used to differentiate between parts, not to indicate their order or degree of importance, or any precondition of mutual existence, etc.

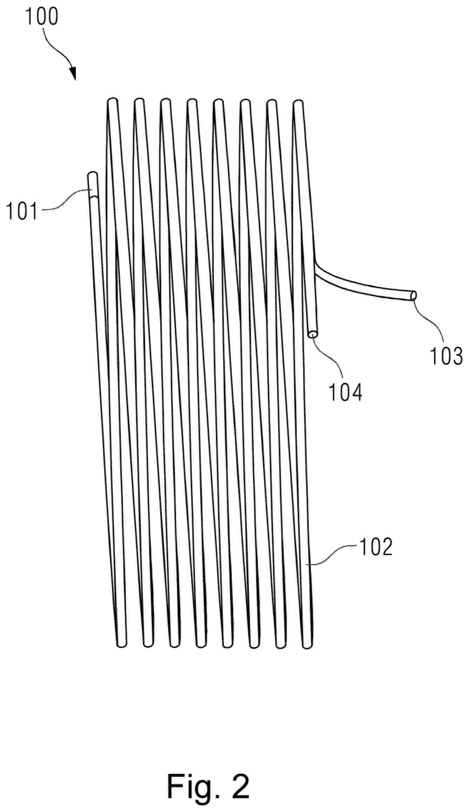

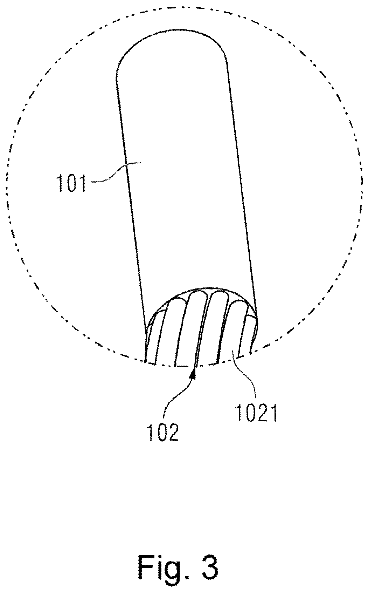

The present embodiment presents a non-inductive coil assembly 100. As shown in Figs. 2 - 4, the non-inductive coil assembly 100 comprises a superconducting joint 101 and a superconducting coil 102, the superconducting joint 101 being configured to be conductive; and the superconducting coil 102 comprising an even number of conducting wires, the even number of conducting wires being helically wound together, a first end of the superconducting coil 102 being connected to the superconducting joint 101, and, at a second end of the superconducting coil 102, the even number of conducting wires dividing into two strands and being respectively helically wound to form an input group 103 and an output group 104, the numbers of conducting wires of the input group 103 and the output group 104 being the same, and current flowing to the superconducting joint 101 via the conducting wire corresponding to the input group 103, and flowing out of the superconducting coil 102 from the conducting wire corresponding to the output group 104.

In the present embodiment, one half of the conducting wire in the superconducting coil 102 corresponds to the input group 103, the direction of current flows from the input group 103 to the superconducting joint 101, the other half of the conducting wire in the superconducting coil 102 corresponds to the output group 104, the direction of current flows from the superconducting joint 101 to the output group 104, and the directions of current of the two are opposite each other, and thus, the superconducting coil 102 as a whole may be seen as a combination of two sub-coils wound in opposite directions, such that the overall superconducting coil 102 is non-inductive. In this type of innovative superconducting coil 102 of the present embodiment, two parts of conducting wire, in which the directions of current are opposite each other, are helically wound together to form a coil, and an amount of displacement of position in space between the two conducting wires, in which the directions of current are opposite each other, is relatively small, causing a reactance effect of the superconducting switch on a circuit and environment to be minimal. In addition, the present solution replaces a conducting wire folded part of a "dual-wire winding method" with the superconducting joint 101, so that an amount of inductance of a bent region is thereby eliminated, and the superconducting wire can also be prevented from breaking at the fold. Moreover, in the present embodiment, because only one whole superconducting coil 102 is wound, compared with the "dual-wire winding method", the winding process of the present invention is simpler, tension of the wire is also easier to control, and this increases stability of the superconducting switch when operating.

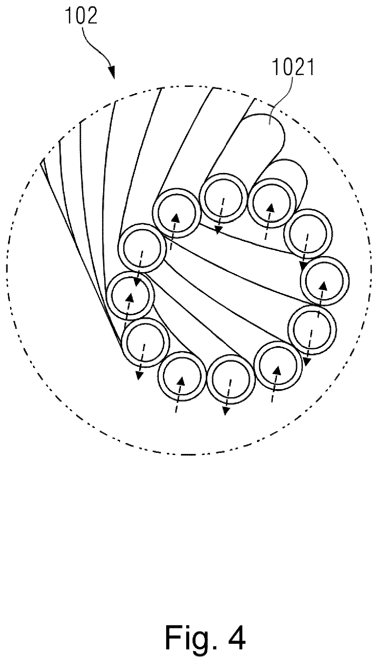

It must be explained that an even number of conducting wires in the superconducting coil 102 are helically wound to form a single strand of twisted conducting wire. The even number of conducting wires may be randomly divided into two strands at the second end, just as long as the two strands are allotted the same number of conducting wires. As shown in Fig. 4, in a preferred embodiment, when an even number of conducting wires are divided into two strands, an interweaving allotting means is used, that is, two conducting wires which are adjacent respectively diverge into the input group 103 and the output group 104. Such a configuration causes the directions of current of the two conducting wires which are adjacent to be opposite each other, thereby minimising the amount of displacement of position in space.

The superconducting joint 101 is configured such that resistance of the superconducting joint 101 is zero when the temperature reduces to a threshold value. The superconducting joint 101 being provided with the above property can realize a superconducting connection between the superconducting coil 102 and the superconducting joint 101, and, in a low temperature situation, resistance at the superconducting joint 101 is zero, which prevents the superconducting joint 101 from influencing the operating performance of the superconducting switch in a no-resistance state.

The non-inductive coil assembly 100 comprises a cylindrical winding frame, the superconducting coil 102 is wound on an outer wall face of the winding frame, and the superconducting joint 101 is connected to the winding frame. Using the above structural configuration, the structure is simple which facilitates manufacturing.

The winding frame is provided with an accommodating slot, and the superconducting joint 101 is clamped in the accommodating slot. By means of providing the accommodating slot, the superconducting joint 101 can be fixed, and at the same time, the superconducting joint 101 is prevented from affecting the arrangement of the superconducting coil 102 on the winding frame. In an alternative embodiment, other means may be used to fix the superconducting joint 101, for example, bonding, ultrasonic welding, etc. Specifically, the shape of the accommodating slot matches the shape of the superconducting joint 101.

It must be explained that, in other alternative embodiments, the superconducting joint 101 also may be fixed at another position. For example, two end faces of the winding frame are provided with a winding end plate, the winding end plate is provided with an accommodating slot, and the superconducting joint 101 is clamped in the accommodating slot. By means of providing the winding end plates, the superconducting coil 102 can be prevented from coming off two ends of the winding frame, the accommodating slot is arranged on the winding end plate, and does not affect the winding of the superconducting coil 102 on the winding frame.

After the superconducting joint 101 is heated to melting point and becomes liquid, the first end of the superconducting coil 102 is inserted inside the superconducting joint 101 of a liquid state, and thereafter, reducing the temperature causes the superconducting joint 101 to change to a solid state, to cause the superconducting coil 102 to fix to the superconducting joint 101. Using the above structural form, while the superconducting coil 102 is fixed to the superconducting joint 101, current can flow from the conducting wire corresponding to the input group 103 into the conducting wire corresponding to the output group 104 by means of the superconducting joint 101. Specifically, when the superconducting joint 101 is manufactured, a mold of a corresponding shape may be provided, the liquid superconducting joint 101 is poured into the mold, and then a first end of the superconducting coil 102 is inserted in the mold, and after solidification, the superconducting joint 101 and superconducting coil 102, which are fixed together, are taken out from the mold.

In the present embodiment, the superconducting joint 101 is cylindrical. In another alternative embodiment, the superconducting joint 101 may be another shape, such as a prism, cube, cuboid or other shape.

The material of the superconducting joint 101 is a lead bismuth alloy. The melting point of the lead bismuth alloy is low, convenient for heating same to a liquid state, so that the processing efficiency of the superconducting joint 101 is high; in addition, the resistivity of the lead bismuth alloy decreases sharply under the effect of a magnetic field, convenient for causing the resistance of the superconducting joint 101 to be zero at a low temperature, thereby realizing a superconducting connection between the superconducting joint 101 and the superconducting coil 102. In an alternative embodiment, another bismuth alloy may be used, such as a tin bismuth alloy, as long as the above-mentioned effect can be achieved.

The present embodiment further provides a manufacturing method for a non-inductive coil assembly 100, the method being used for manufacturing the non-inductive coil assembly 100 described above, and the manufacturing method comprising the following steps:
S1, helically winding an even number of conducting wires together to form the superconducting coil 102;
S2, fixing a first end of the superconducting coil 102 to the superconducting joint 101; and
S3, at a second end of the superconducting coil 102, dividing the superconducting coil 102 into two strands of the same number of conducting wires, and respectively helically winding the strands to form an input group 103 and an output group 104, wherein when the superconducting coil 102 is energized, current flows from the input group 103 to the output group 104.

In the present embodiment, one half of the conducting wire in the superconducting coil 102 corresponds to the input group 103, the direction of current flows from the input group 103 to the superconducting joint 101, the other half of the conducting wire in the superconducting coil 102 corresponds to the output group 104, the direction of current flows from the superconducting joint 101 to the output group 104, and the directions of current of the two are opposite each other, and thus, the superconducting coil 102 as a whole may be seen as a combination of two sub-coils wound in opposite directions, such that the overall superconducting coil 102 is non-inductive. In this type of innovative superconducting coil 102 of the present solution, two parts of conducting wire, in which the directions of current are opposite each other, are helically wound together to form a coil, and an amount of displacement of position in space between the two conducting wires, in which the directions of current are opposite each other, is relatively small, causing a reactance effect of the superconducting switch on a circuit and environment to be minimal. In addition, the present solution replaces a conducting wire folded part of a "dual-wire winding method" with the superconducting joint 101, so that an amount of inductance of a bent region is thereby eliminated, and the superconducting wire can also be prevented from breaking at the fold. Moreover, in the present solution, because only one whole superconducting coil 102 is wound, compared with the "dual-wire winding method", the winding process of the present invention is simpler, tension of the wire is also easier to control, and this increases stability of the superconducting switch when operating.

It must be explained that the order of the above steps is not fixed; for example, the order may also proceed S1, S3, S2.

The non-inductive coil assembly 100 further comprises a cylindrical winding frame, and the following steps are further comprised between step S2 and step S3:
S21, fixing the superconducting joint 101 to the winding frame; and
S22, winding the superconducting coil 102 on the winding frame.

The above are merely embodiments of the present invention, and are not intended to limit it. Any modifications, equivalent substitutions or improvements etc. made within the spirit and principles of the present invention shall be included in the scope of protection thereof. Although particular embodiments of the present invention are described above, those skilled in the art should understand that this is merely an exemplary explanation, and the scope of protection of the present invention is defined by the attached claims. Those skilled in the art may make various changes or modifications to these embodiments, without departing from the present invention as defined by the claims.

## Claims

1. A non-inductive coil assembly (100), wherein the non-inductive coil assembly (100) comprises:
a superconducting joint (101), the superconducting joint (101) configured to be conductive; and
a superconducting coil (102), the superconducting coil (102) comprising an even number of conducting wires,
the even number of conducting wires being helically wound together,
a first end of the superconducting coil (102) being connected to the superconducting joint (101), and,
at a second end of the superconducting coil (102), the even number of conducting wires dividing into two strands and being respectively helically wound to form an input group (103) and an output group (104),
the numbers of conducting wires of the input group (103) and the output group (104) being the same, and
current flowing to the superconducting joint (101) via the conducting wire corresponding to the input group (103), and
flowing out of the superconducting coil (102) from the conducting wire corresponding to the output group (104).

2. The non-inductive coil assembly (100) as claimed in claim 1, wherein the superconducting joint (101) is configured such that resistance of the superconducting joint (101) is zero when temperature reduces to a threshold value.

3. The non-inductive coil assembly (100) as claimed in claim 1 or 2, wherein the non-inductive coil assembly (100) comprises a cylindrical winding frame, the superconducting coil (102) is wound on an outer wall face of the winding frame, and the superconducting joint (101) is connected to the winding frame.

4. The non-inductive coil assembly as claimed in claim 3, wherein the winding frame is provided with an accommodating slot, and the superconducting joint (101) is clamped in the accommodating slot.

5. The non-inductive coil assembly as claimed in claim 3 or 4, wherein two end faces of the winding frame are provided with a winding end plate, the winding end plate is provided with an accommodating slot, and the superconducting joint (101) is clamped in the accommodating slot.

6. The non-inductive coil assembly (100) as claimed in any one of claims 1 - 5, wherein after the superconducting joint (101) is heated to melting point and becomes liquid, the first end of the superconducting coil (102) is inserted inside the superconducting joint (101) of a liquid state, and thereafter, reducing the temperature causes the superconducting joint (101) to change to a solid state, to cause the superconducting coil (102) to fix to the superconducting joint (101).

7. The non-inductive coil assembly (100) as claimed in any one of claims 1 - 6, wherein the superconducting joint (101) is cylindrical.

8. The non-inductive coil assembly (100) as claimed in any one of claims 1 - 7, wherein the material of the superconducting joint (101) is a lead bismuth alloy.

9. A manufacturing method for a non-inductive coil assembly (100), the method in particular, being used for manufacturing the non-inductive coil assembly (100) as claimed in any one of claims 1 - 8, wherein the manufacturing method comprises the following steps:
S1, helically winding the even number of conducting wires together to form the superconducting coil (102);
S2, fixing a first end of the superconducting coil (102) to the superconducting joint (101); and
S3, at a second end of the superconducting coil (102), dividing the superconducting coil (102) into two strands of the same number of conducting wires, and respectively helically winding the strands into an input group (103) and an output group (104), wherein when the superconducting coil (102) is energized, current flows from the input group (103) to the output group (104).

10. The manufacturing method for the non-inductive coil assembly (100) as claimed in claim 9, wherein the non-inductive coil assembly (100) further comprises a cylindrical winding frame, and the following steps are further comprised between step S2 and step S3:
S21, fixing the superconducting joint (101) to the winding frame; and
S22, winding the superconducting coil (102) on the winding frame.

## Patentansprüche

1. Nicht-induktive Spulenanordnung (100), wobei die nicht-induktive Spulenanordnung (100) umfasst:
einen supraleitenden Anschluss (101), wobei der supraleitende Anschluss (101) ausgelegt ist, leitfähig zu sein; und
eine supraleitende Spule (102), wobei die supraleitende Spule (102) eine gerade Anzahl an leitenden Drähten umfasst,
wobei die gerade Anzahl an leitenden Drähten spiralförmig miteinander gewickelt ist,
wobei ein erstes Ende der supraleitenden Spule (102) mit dem supraleitenden Anschluss (101) verbunden ist und
wobei an einem zweiten Ende der supraleitenden Spule (102) die gerade Anzahl an leitenden Drähten in zwei Stränge aufgeteilt ist und jeweils spiralförmig gewickelt sind, um eine Eingabegruppe (103) und eine Ausgabegruppe (104) zu bilden,
wobei die Anzahl an leitenden Drähten der Eingabegruppe (103) und der Ausgabegruppe (104) gleich ist und
wobei Strom zu dem supraleitenden Anschluss (101) durch den leitenden Draht fließt, welcher der Eingabegruppe (103) entspricht, und
aus der supraleitenden Spule (102) von dem leitenden Draht fließt, welcher der Ausgabegruppe (104) entspricht.

2. Nicht-induktive Spulenanordnung (100) nach Anspruch 1, wobei der supraleitende Anschluss (101) derartig ausgelegt ist, dass der Widerstand des supraleitenden Anschlusses (101) null ist, wenn die Temperatur auf einen Schwellenwert absinkt.

3. Nicht-induktive Spulenanordnung (100) nach Anspruch 1 oder 2, wobei die nicht-induktive Spulenanordnung (100) ein zylindrisches Wickelgestell umfasst, die supraleitende Spule (102) auf eine Außenwandfläche des Wickelgestells gewickelt ist und der supraleitende Anschluss (101) mit dem Wickelgestell verbunden ist.

4. Nicht-induktive Spulenanordnung nach Anspruch 3, wobei das Wickelgestell mit einer Aufnahmeaussparung vorgesehen ist und der supraleitende Anschluss (101) in der Aufnahmeaussparung festgeklemmt ist.

5. Nicht-induktive Spulenanordnung nach Anspruch 3 oder 4, wobei zwei Stirnflächen des Wickelgestells mit einer Wickelendplatte vorgesehen sind, die Wickelendplatte mit einer Aufnahmeaussparung vorgesehen ist und der supraleitende Anschluss (101) in der Aufnahmeaussparung festgeklemmt ist.

6. Nicht-induktive Spulenanordnung (100) nach einem der Ansprüche 1 - 5, wobei, nachdem der supraleitende Anschluss (101) bis zum Schmelzpunkt erhitzt und flüssig geworden ist, das erste Ende der supraleitenden Spule (102) in das Innere des supraleitenden Anschlusses (101) in flüssigem Zustand eingesetzt wird, und danach ein Verringern der Temperatur den supraleitenden Anschluss (101) veranlasst, in einen festen Zustand zu wechseln, um die supraleitende Spule (102) zu veranlassen, sich an dem supraleitenden Anschluss (101) zu fixieren.

7. Nicht-induktive Spulenanordnung (100) nach einem der Ansprüche 1 - 6, wobei der supraleitende Anschluss (101) zylindrisch ist.

8. Nicht-induktive Spulenanordnung (100) nach einem der Ansprüche 1 - 7, wobei das Material des supraleitenden Anschlusses (101) eine Blei-Wismut-Legierung ist.

9. Herstellungsverfahren für eine nicht-induktive Spulenanordnung (100), wobei das Verfahren insbesondere zur Herstellung der nicht-induktiven Spulenanordnung (100) nach einem der Ansprüche 1-8 verwendet wird, wobei das Herstellungsverfahren die folgenden Schritte umfasst:
S1, spiralförmiges Wickeln der geraden Anzahl an leitenden Drähten miteinander, um die supraleitende Spule (102) zu bilden;
S2, Fixieren eines ersten Endes der supraleitenden Spule (102) an dem supraleitenden Anschluss (101); und
S3, Aufteilen der supraleitenden Spule (102) an einem Ende der supraleitenden Spule (102) in zwei Stränge mit gleicher Anzahl an leitenden Drähten und jeweils Wickeln der Stränge in eine Ausgabegruppe (103) und eine Eingabegruppe (104), wobei, wenn die supraleitende Spule (102) erregt wird, Strom von der Eingabegruppe (103) zu der Ausgabegruppe (104) fließt.

10. Herstellungsverfahren für die nicht-induktive Spulenanordnung (100) nach Anspruch 9, wobei die nicht-induktive Spulenanordnung (100) ferner ein zylindrisches Wickelgestell umfasst und ferner die folgenden Schritte zwischen Schritt S2 und Schritt S3 umfasst sind:
S21, Fixieren des supraleitenden Anschlusses (101) an dem Wickelgestell; und
S22, Wickeln der supraleitenden Spule (102) auf das Wickelgestell.

## Revendications

1. Ensemble bobine non inductive (100), l'ensemble bobine non inductive (100) comprenant :
un joint supraconducteur (101), le joint supraconducteur (101) étant conçu pour être conducteur ; et
une bobine supraconductrice (102), la bobine supraconductrice (102) comprenant un nombre pair de fils conducteurs,
le nombre pair de fils conducteurs étant enroulés ensemble de manière hélicoïdale,
une première extrémité de la bobine supraconductrice (102) étant reliée au joint supraconducteur (101), et
au niveau d'une seconde extrémité de la bobine supraconductrice (102), le nombre pair de fils conducteurs se divisant en deux torons et étant respectivement enroulés de manière hélicoïdale pour former un groupe d'entrée (103) et un groupe de sortie (104),
le nombre de fils conducteurs du groupe d'entrée (103) et du groupe de sortie (104) étant le même, et
le courant arrivant dans le joint supraconducteur (101) par le biais du fil conducteur correspondant au groupe d'entrée (103), et
sortant du joint supraconducteur (102) par le fil conducteur correspondant au groupe de sortie (104).

2. Ensemble bobine non inductive (100) selon la revendication 1, dans lequel le joint supraconducteur (101) est conçu de telle sorte que la résistance du joint supraconducteur (101) soit nulle lorsque la température diminue jusqu'à une valeur seuil.

3. Ensemble bobine non inductive (100) selon la revendication 1 ou 2, l'ensemble bobine non inductive (100) comprenant un support d'enroulement cylindrique, la bobine supraconductrice (102) étant enroulée sur une face de paroi extérieure du support d'enroulement, et le joint supraconducteur (101) étant relié au support d'enroulement.

4. Ensemble bobine non inductive selon la revendication 3, dans lequel le support d'enroulement est pourvu d'une fente de réception, et le joint supraconducteur (101) est mis en prise dans la fente de réception.

5. Ensemble bobine non inductive selon la revendication 3 ou 4, dans lequel deux faces d'extrémité du support d'enroulement sont pourvues d'une plaque d'extrémité d'enroulement, la plaque d'extrémité d'enroulement est pourvue d'une fente de réception, et le joint supraconducteur (101) est mis en prise dans la fente de réception.

6. Ensemble bobine non inductive (100) selon l'une quelconque des revendications 1 à 5, dans lequel, après que le joint supraconducteur (101) a été chauffé jusqu'au point de fusion et est devenu liquide, la première extrémité de la bobine supraconductrice (102) est insérée dans le joint supraconducteur (101) à l'état liquide, et une diminution de la température fait ensuite passer le joint supraconducteur (101) à un état solide, de façon à ce que la bobine supraconductrice (102) se fixe au joint supraconducteur (101).

7. Ensemble bobine non inductive (100) selon l'une quelconque des revendications 1 à 6, dans lequel le joint supraconducteur (101) est cylindrique.

8. Ensemble bobine non inductive (100) selon l'une quelconque des revendications 1 à 7, dans lequel le matériau du joint supraconducteur (101) est un alliage de plomb et de bismuth.

9. Procédé de fabrication pour un ensemble bobine non inductive (100), le procédé étant, en particulier, utilisé pour fabriquer l'ensemble bobine non inductive (100) selon l'une quelconque des revendications 1 à 8, le procédé de fabrication comprenant les étapes suivantes :
S1, enrouler ensemble de manière hélicoïdale le nombre pair de fils conducteurs pour former la bobine supraconductrice (102) ;
S2, fixer une première extrémité de la bobine supraconductrice (102) au joint supraconducteur (101) ; et
S3, au niveau d'une seconde extrémité de la bobine supraconductrice (102), diviser la bobine supraconductrice (102) en deux torons comportant le même nombre de fils conducteurs, et enrouler respectivement les torons de manière hélicoïdale pour former un groupe d'entrée (103) et un groupe de sortie (104), le courant circulant, lorsque la bobine supraconductrice (102) est excitée, du groupe d'entrée (103) au groupe de sortie (104).

10. Procédé de fabrication pour l'ensemble bobine non inductive (100) selon la revendication 9, l'ensemble bobine non inductive (100) comprenant, en outre, un support d'enroulement cylindrique, et le procédé comprenant, en outre, les étapes suivantes entre l'étape S2 et l'étape S3 :
S21, fixer le joint supraconducteur (101) au support d'enroulement ; et
S22, enrouler la bobine supraconductrice (102) sur le support d'enroulement.
